# EUROPEAN PATENT SPECIFICATION

(11) **EP 2 026 352 B1**
(45) Date of publication and mention of the grant of the patent: **30.09.2009**
(21) Application number: 07112695.7
(22) Date of filing: 18.07.2007
(51) Int. Cl.: G11C 5/06, G11C 11/4063

(54) **Common modules for DDRII SDRAM and DDRIII SDRAM**
Gemeinsame Module für DDRII-SDRAM und DDRIII-SDRAM
Modules communs pour DDRII SDRAM et DDRIII SDRAM

(43) Date of publication of application: 18.02.2009
(73) Proprietor: Giga-Byte Technology Co., Ltd., Taipei-Hsien 231 (TW)
(72) Inventor: Chen, Chin-Hui, 231Taipei Hsien (TW); Lin, Hou-Yuan, 231 Taipei Hsien (TW)
(74) Representative: Charrier, Rapp & Liebau

(56) References cited:
- US-A1- 2006 077 731
- US-A1- 2006 262 587
- US-B1- 6 466 472

## Description

### BACKGROUND OF THE INVENTION

### Field of the Invention

The invention relates to the method of using a common module, and more particularly to a common module for a double data rate-synchronous II synchronous dynamic random access memory (DDRII SDRAM) and a DDRIII SDRAM.

### Description of the Related Art

Double data rate-synchronous III synchronous dynamic random access memories (DDRIII SDRAMs) have been developed to meet the requirements of high transfer rate and low power consumption. The operating voltage of a DDRIII SDRAM has been reduced over the previous generation from 2.5V to 1.8V, thus, power consumption has been correspondingly reduced, resulting in longer operating life of application devices (such as computers and mobile phones). Additionally, the DDRIII SDRAM packaging techniques, pins, and signals have also improved over previous generations.

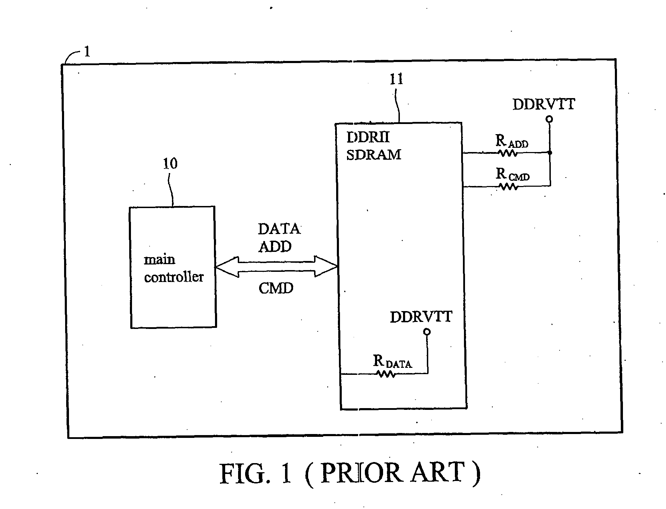

Fig. 1 shows a conventional main board of a DDRII SDRAM. In Fig. 1, a DDRII SDRAM 11 is installed in a DDRII slot of a main board 1. A main controller 10 provides data signals DATA, address signals ADD, and control signals CMD to the DDRII SDRAM 11. The main controller 10 can be an Intel north bridge chipset or an AMD central processing unit (CPU). Referring to Fig. 1, termination resistors R_{ADD} and R_{CMD} required for the address signals ADD and the control signals CMD are disposed on the main board 1, and termination resistors R_{DATA} for the data signals DATA are built into the DDRII SDRAM 11.

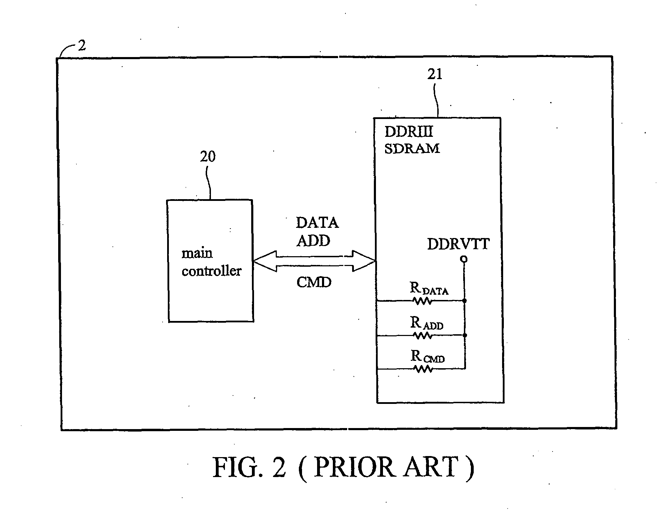

Fig. 2 shows a conventional main board of a DDRIII SDRAM. In Fig. 2, a DDRIII SDRAM 21 is installed in a DDRIII slot of a main board 2. A main controller 20 provides data signals DATA, address signals ADD, and control signals CMD to the DDRIII SDRAM 21. The main controller 20 can be an Intel north bridge chipset or an AMD CPU. Referring to Fig. 2, termination resistors R_{DATA}, R_{ADD}, and R_{CMD} required for the data signals DATA, the address signals ADD, and the control signals CMD are built into the DDRIII SDRAM 21. Compared with the main board 1 of the DDRII SDRAM 11 in Fig. 1, the termination resistors R_{ADD} and R_{CMD} of the DDRIII SDRAM 21 are removed from the main board 2 and disposed inside the DDRIII SDRAM 21.

As described, the specifications of a DDRII SDRAM and a DDRIII SDRAM are different. When a DDRII SDRAM or a DDRIII SDRAM is used selectively, a different main board is required for each.
[new] US 6 466 472 B1 discloses a common module for DDR SDRM and SDRAM on a motherboard, which computes and determines the resistance of the terminators on the motherboard so that the work current is controlled within the range allowed by an SDRAM controller, and can achieve the object of a DDR DRAM and SDRAM common layout without the need of an extra quick switch IC.

A common module for a DDRII SDRAM and a DDRIII SDRAM is thus provided. The common module allows selective use of a DDRII SDRAM or a DDRIII SDRAM without requiring two main boards having different specifications.

### BRIEF SUMMARY OF THE INVENTION

A method of using a common module according to the invention is shown in claim 1. An exemplary embodiment of a common module for a double data rate-synchronous II synchronous dynamic random access memory DDRII SDRAM) and a DDRIII SDRAM, is applied in a computer and comprises a first bus, a termination circuit card, a first slot, and a second slot. The first bus transmits a plurality of signals. The termination circuit card comprises a plurality of termination resistors. The first slot is disposed on the common module and coupled to the first bus. The DDRII SDRAM is selectively installed in the first slot. The second slot is disposed on the common module and coupled to the first bus. The DDRIII SDRAM or the termination circuit card is installed in the second slot. When the DDRII SDRAM is installed in the first slot, the termination circuit card is installed in the second slot.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:

Fig. 1 shows a conventional main board of a DDRII SDRAM;

Fig. 2 shows a conventional main board of a DDRIII SDRAM;

Figs. 3a and 3b show an exemplary embodiment of a common module for a DDRII SDRAM and a DDRIII SDRAM;

Fig. 4a shows the common module of Fig. 3a in the first mode;

Fig. 4b shows the termination circuit card of Fig. 3a;

Fig. 5 shows the common module of Fig. 3a in the second mode;

Figs. 6a and 6b show an exemplary embodiment of a common module for a DDRII SDRAM and a DDRIII SDRAM;

Fig. 7 shows the common module of Fig. 6a in the first mode;

Fig. 8 shows the common module of Fig. 6a in the second mode;

Figs. 9a and 9b show an exemplary embodiment of a common module for a DDRII SDRAM and a DDRIII SDRAM;

Fig. 10 shows the common module of Fig. 9a in the first mode; and

Fig. 11 shows the common module of Fig. 9a in the second mode.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

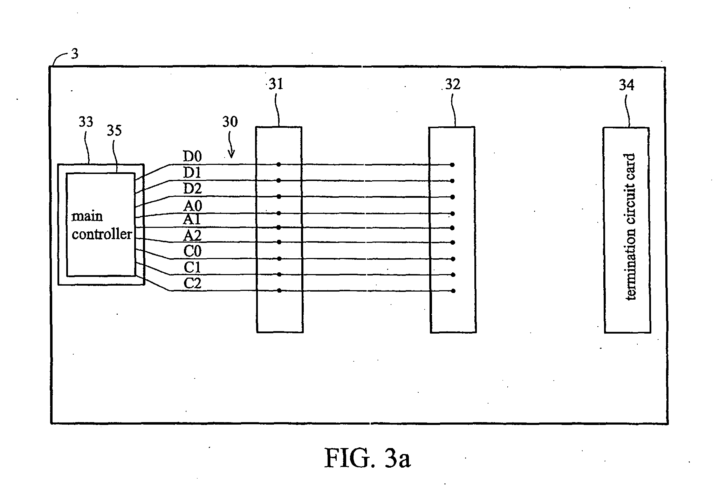

Common modules for a double data rate-synchronous II synchronous dynamic random access memory (DDRII SDRAM) and a DDRIII SDRAM are provided. In an exemplary embodiment of a common module for a DDRII SDRAM and a DDRIII SDRAM in Fig. 3a, a common module 3 is applied in a computer system and comprises a first bus 30, at least one first slot 31, a second slot 32, a third slot 33, and a termination circuit card 34. Note that the termination circuit card 34 is not fixed in the position represented in Fig. 3a, and the position of the termination circuit card 34 indicates that the termination circuit card 34 is included in the common module 3. The first to third slots 31-33 are disposed on the common module 3 and coupled to the first bus 30. A main controller 35 of the computer system is installed in the third slot 33.

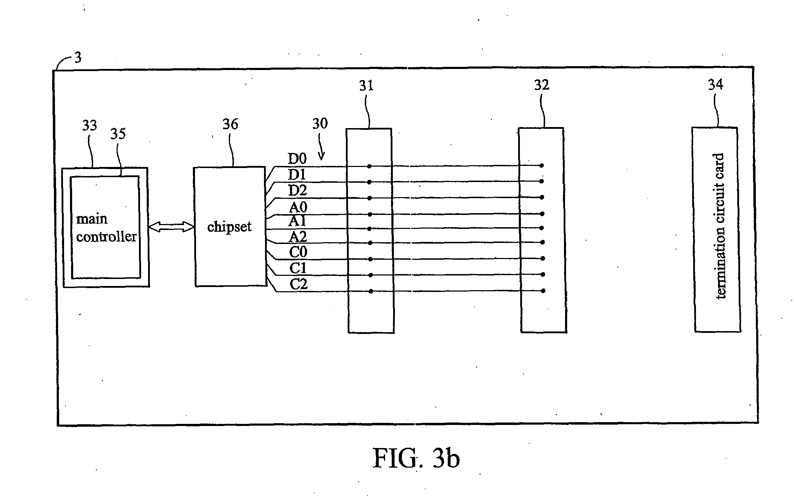

The main controller 35 provides a plurality of signals to the first bus 30. In some embodiments, the main controller 35 is an AMD CPU. In some embodiments, as shown in Fig. 3b, the common module 3 further comprises a chipset 36 coupled to the main controller 35, and the chipset 36 transmits signals from the main controller 35 to the first bus 30. In the embodiment of Fig. 3b, the main controller 35 is an Intel CPU, and the chipset 36 is implemented by a north bridge chipset.

The signals from the main controller 35 comprise data signals, address signals, and control signals. In the following description, data signals D0-D2, address signals A0-A2, and control signals C0-C2 are given as an example.

The common module 3 operates in two modes, the first is DDRII SDRAM mode, and the second is DDRIII SDRAM mode.

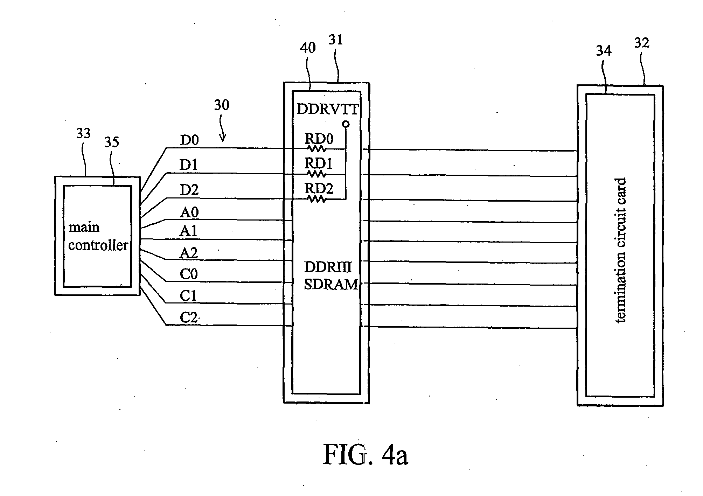

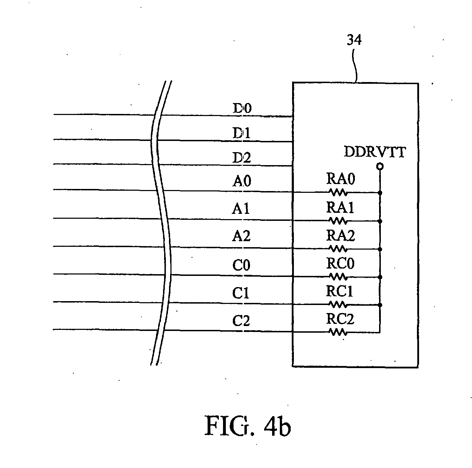

Fig. 4a shows the common module 3 in the first mode. Referring to Fig. 4a, in the first mode, a DDRII SDRAM 40 is installed in the first slot 31, and the termination circuit card 34 is installed in the second slot 32. Referring to Fig. 4b, the termination circuit card 34 comprises a plurality of termination resistors R, and the termination resistors R match the address signals A0-A2 and the control signals C0-C2 in impedance. For example, termination resistors RAO-RA2 respectively match the address signals A0-A2, and termination resistors RCO-RC2 respectively match the control signals C0-C2. Termination resistors matching the data signals D0-D2 are built into the DDRII SDRAM 40. When the termination circuit card 34 is installed in the second slot 32, the termination resistors RAO-RA2 and RCO-RC2 are correspondingly coupled to the first bus 30, thus, the termination resistors RAO-RA2 coupled the address signals A0-A2 respectively, and the termination resistors couple the RCO-RC2 control signals C0-C2 respectively.

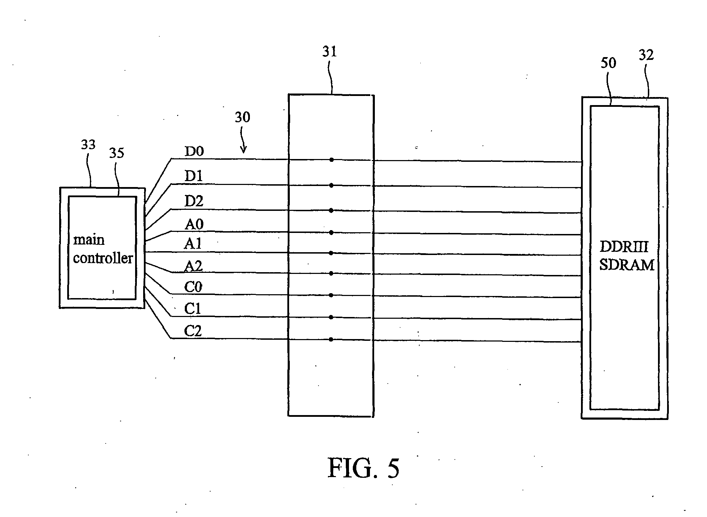

Fig. 5 shows the common module 3 in the second mode. Referring to Fig. 5, in the second mode, the DDRII SDRAM 40 is removed from the first slot 31, and the termination circuit card 24 is removed from the second slot 32. The DDRIII SDRAM 50 is installed in the second slot 32. According to the specification of the DDRIII SDRAM 50, termination resistors for the data signals D0-D2, the address signals A0-A2, and the control signals C0-C2 are built into the DDRIII SDRAM 50, and the termination circuit card 34 is no longer required.

According to the embodiment of Figs. 3a-5, the DDRII SDRAM 40 and the termination circuit card 34 are installed when DDRII SDRAM 40 is used, and the DDRIII DRAM 50 is installed when the DDRIII SDRAM50 is used, thus, two main boards with different specifications are not required.

Additionally, in the embodiment of Figs. 3a-5, one first slot 31 is given as an example. In practice, the common module 3 may comprise a plurality of serially coupled first slots 31 . In the first mode, one DDRII SDRAM is installed in one first slot 31.

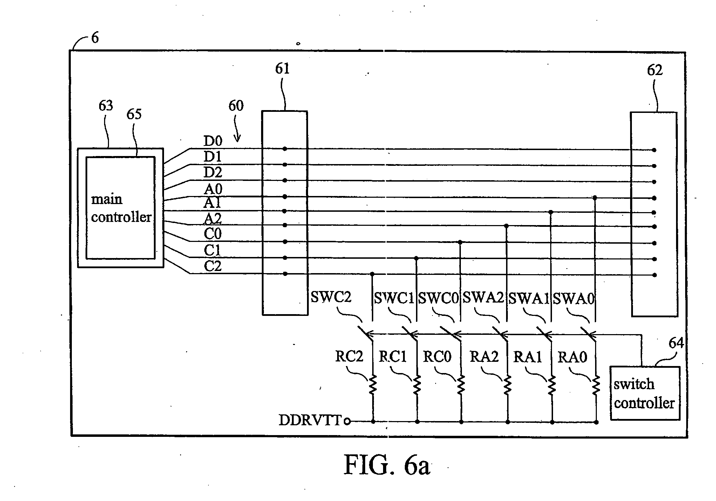

In an exemplary embodiment of a common module for a DDRII SDRAM and a DDRIII SDRAM in Fig. 6a, a common module 6 is applied in a computer system and comprises a first bus 60, at least one first slot 61, a second slot 62, a third slot 63, a plurality of termination resistors R, a plurality of switches SW, and a switch controller 64. The first to third slots 61-63 are disposed on the common module 6 and coupled to the first bus 60. A main controller 65 of the computer system is installed in the third slot 63. The switches SW are coupled between the termination resistors R and the first bus 60.

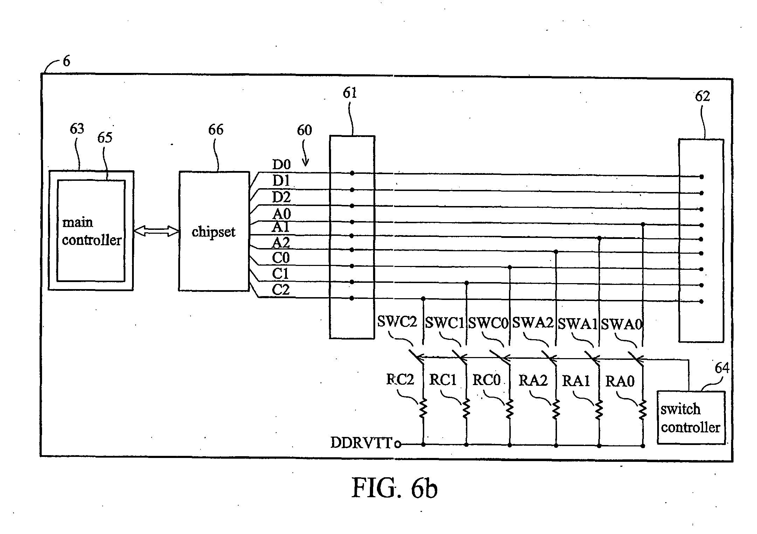

The main controller 65 provides a plurality of signals to the first bus 60. In some embodiments, the main controller 65 is an AMD CPU. In some embodiments, as shown in Fig. 6b, the common module 6 further comprises a chipset 66 coupled to the main controller 65, and the chipset 66 transmits signals from the main controller 65 to the first bus 60. In the embodiment of Fig. 6b, the main controller 65 is an Intel CPU, and the chipset 66 is implemented by a north bridge chipset.

The signals from the main controller 65 comprise data signals, address signals, and control signals. In the following description, data signals D0-D2, address signals A0-A2, and control signals C0-C2 are given as an example.

The termination resistors R match the data signals A0-A2 and the control signals C0-C2. For example, the termination resistors RAO-RA2 respectively match the address signals A0-A2, and the termination resistors RCO-RC2 respectively match the control signals C0-C2. The switches SW comprise switches SWAO-SWA2 and switches SWCO-SWC2. The switches SWAO-SWA2 are coupled between the termination resistor RAO-RA2 and the address signals A0-A2 respectively, and the switches SWCO-SWC2 are coupled between the termination resistor RCO-RC2 and the control signals C0-C2 respectively.

The common module 6 operates in two modes, the first is DDRII SDRAM mode, and the second is DDRIII SDRAM mode.

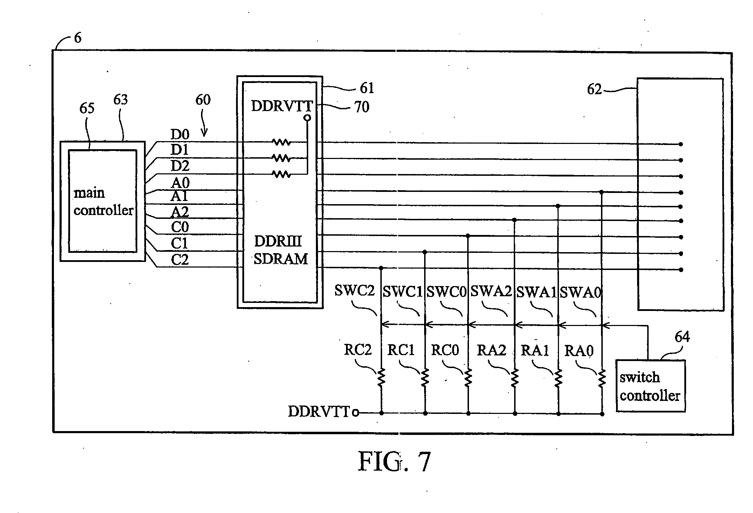

Fig. 7 shows the common module 6 in the first mode. Referring to Fig. 7, in the first mode, a DDRII SDRAM 70 is installed in the first slot 61, and the switch controller 64 turns on the switches SWAO-SWA2 and SWCO-SWC2. The termination resistors RAO-RA2 and RCO-RC2 are correspondingly coupled to the first bus 60, thus, the termination resistors RAO-RA2 couple the address signals A0-A2, and the termination resistors RCO-RC2 coupled control signals C0-C2 respectively. Moreover, termination resistors matching the data signals D0-D2 are built into the DDRII SDRAM 70.

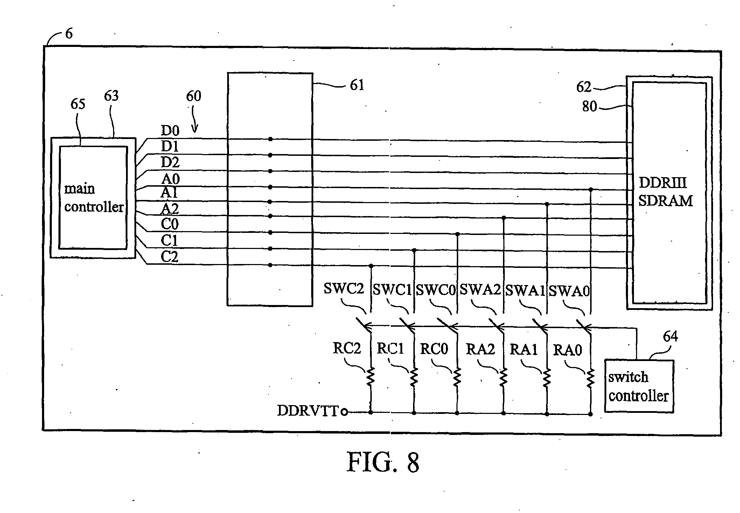

Fig. 8 shows the common module 6 in the second mode. Referring to Fig. 8, in the second mode, the DDRII SDRAM 70 is removed from the first slot 61, and the DDRIII SDRAM 80 is installed in the second slot 62. The switch controller 64 turns off the switches SWAO-SWA2 and SWCO-SWC2. According to the specification of the DDRIII SDRAM 80, termination resistors for the data signals D0-D2, the address signals A0-A2, and the control signals C0-C2 are built into the DDRIII SDRAM 80, and the switches SWAO-SWA2 and SWCO-SWC2 34 are thus no longer coupled to the first bus 60.

According to the embodiment of Figs. 6a-8, when the DDRII SDRAM 70 or the DDRIII SDRAM 80 is used, the switches SW between the termination resistors R and the first bus 61 are selectively turned on or off, thus, two main boards with different specifications are not required.

Moreover, in the embodiment of Figs. 6a-8, one first slot 61 is given as an example. In practice the common module 6 may comprise a plurality of serially coupled first slots 61 . In the first mode, one DDRII SDRAM is installed in one first slot 61.

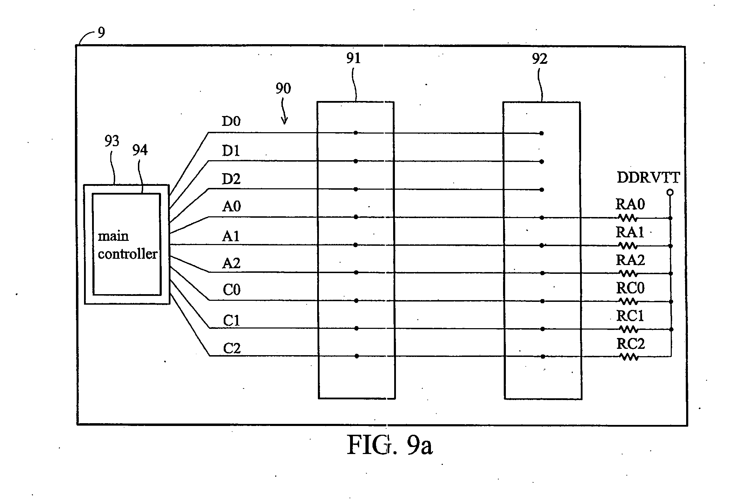

In an exemplary embodiment of a common module for a DDRII SDRAM and a DDRIII SDRAM in Fig. 9a, a common module 9 is applied in a computer system and comprises a first bus 90, at least one first slot 91, a second slot 92, a third slot 93, and a plurality of termination resistors R. The first to third slots 91-93 are disposed on the common module 9 and coupled to the first bus 90. A main controller 94 of the computer system is installed in the third slot 93. The termination resistors R are correspondingly coupled to the first bus 90.

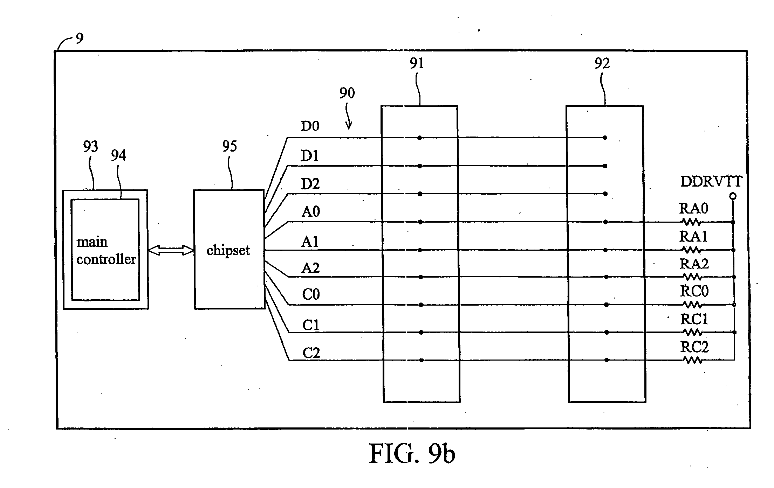

The main controller 94 provides a plurality of signals to the first bus 90. In some embodiments, the main controller 94 is an AMD CPU. In some embodiments, as shown in Fig. 9b, the common module 9 further comprises a chipset 95 coupled to the main controller 94, and the chipset 95 transmits signals from the main controller 94 to the first bus 90. In the embodiment of Fig. 9b, the main controller 94 is an Intel CPU, and the chipset 95 is implemented by a north bridge chipset.

The signals from the main controller 94 comprise data signals, address signals, and control signals. In the following description, data signals D0-D2, address signals A0-A2, and control signals C0-C2 are given as an example.

The termination resistors R are correspondingly coupled to the first bud 90 and match the data signals A0-A2 and the control signals C0-C2. For example, the termination resistors RAO-RA2 respectively match the address signals A0-A2, and the termination resistors RCO-RC2 respectively match the control signals C0-C2.

The common module 9 operates in two modes, the first is DDRII SDRAM mode, and the second is DDRIII SDRAM mode.

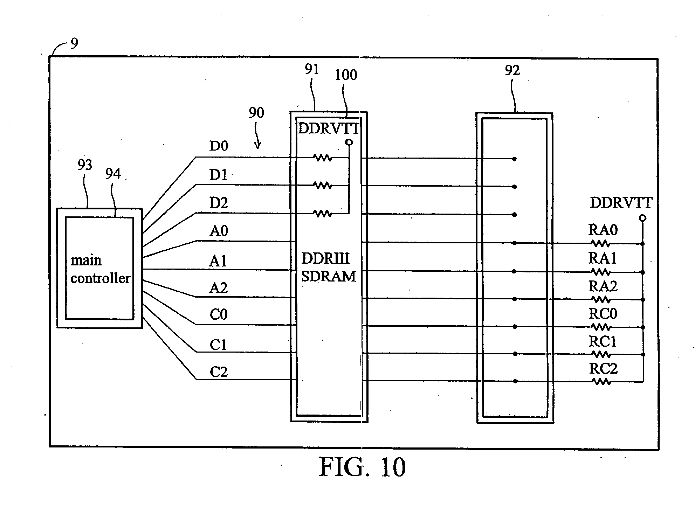

Fig. 10 shows the common module 9 in the first mode. Referring to Fig. 10, in the first mode, a DDRII SDRAM 100 is installed in the first slot 91. Termination resistors matching the data signals D0-D2 are built into the DDRII SDRAM 100. Thus, the data signals D0-D2, the address signals A0-A2, and the control signals C0-C2 couple the matched termination resistors.

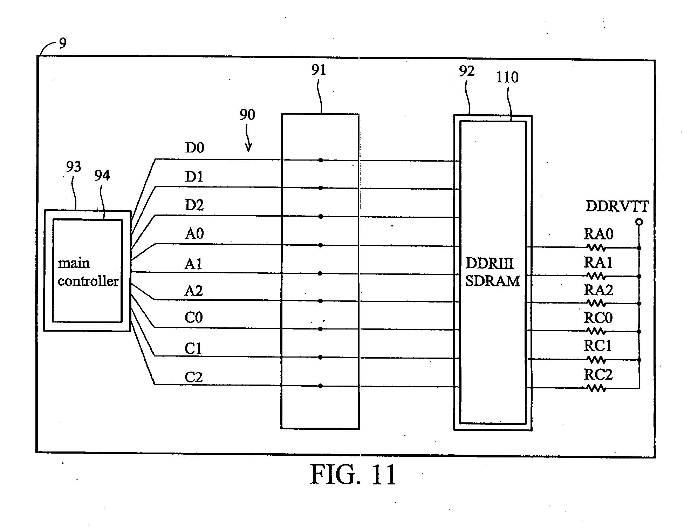

Fig. 11 shows the common module 9 in the second mode. Referring to Fig. 11, in the second mode, the DDRII SDRAM 100 is removed from the first slot 91, and a DDRIII SDRAM 110 is installed in the second slot 92.

In some embodiments, a value of each termination resistor R is between 0 ohms and 100ohm. In some embodiments, the value of each termination resistor R is between 10 ohms and 100 ohms.

According to the embodiment of Figs. 9a-11, when the DDRII SDRAM 100 or the DDRIII SDRAM 110 is used, the DDRII SDRAM 100 or the DDRIII SDRAM 110 is selectively installed in the common module 9. Thus, the common module of the invention eliminates the need for two main boards with different specifications.

Additionally, in the embodiment of Figs. 9a-11, one first slot 91 is given as an example. In practice, the common module 9 may comprise a plurality of serially coupled first slots 91. In the first mode, one DDRII SDRAM is installed in one first slot 91.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A method of using a common module (3) operating in a first mode or a second mode and having a first slot (31) and a second slot (32), and a bus (30), wherein a double data rate-synchronous II synchronous dynamic random access memory (DDRII SDRAM) and a DDRIII SDRAM can be inserted, comprising:
coupling the first slot (31) and the second slot (32) to the bus (30);
**characterized by**:
in the first mode
inserting the DDRII SDRAM in the first slot (31); and
inserting a termination circuit card (34) in the second slot (32);
in the second mode
removing the DDRII SDRAM from the first slot (31);
removing the termination circuit card (34) from the second slot (32); and
inserting the DDRIIISDRAM in the second slot (32).

2. The method as claimed in claim 1 further comprising inserting a main controller (35) in a third slot (33) of the common module (3), wherein the main controller (35) provides signals to the first slot (31) and the second slot (32) through a bus (30).

3. The method as claimed in claim 2 further coupling a chipset to the main controller (35) and transmitting the signals to the first bus (30) through the chipset.

4. The method as claimed in claim 2,
providing a plurality of first termination resistors (RA0-RA2) and a plurality of second termination resistors (CA0-CA2) to the termination circuit card; and
matching the first termination resistor (RA0-RA2) with address signals (A0-A2) among the signals, and
matching the second termination resistor (CA0-CA2) with control signals (C0-C2) among the signals.

5. The method as claimed in claim 1, further comprising correspondingly coupling the termination circuit card (34) to the bus (30).

## Patentansprüche

1. Verfahren zur Verwendung eines gemeinsamen Moduls (3), das in einer ersten Betriebsart oder einer zweiten Betriebsart arbeitet und einen ersten Steckplatz (31) und einen zweiten Steckplatz (32) und einen Bus (30) aufweist, wobei ein dynamischer Synchron-Synchron-Direktzugriffsspeicher mit doppelter Datenrate (DDRII SDRAM) und ein DDRIII SDRAM eingesteckt werden können, umfassend:
Koppeln des ersten Steckplatzes (31) und des zweiten Steckplatzes (32) mit dem Bus (30);
**gekennzeichnet durch**:
in der ersten Betriebsart
Einstecken des DDRII SDRAM in den ersten Steckplatz (31); und
Einstecken einer Abschlussleiterplatte (34) in den zweiten Steckplatz (32); in der zweiten Betriebsart
Entfernen des DDRII SDRAM aus dem ersten Steckplatz (31);
Entfernen der Anschlussleiterplatte (34) aus dem zweiten Steckplatz (32); und
Einstecken des DDRIII SDRAM in den zweiten Steckplatz (32).

2. Verfahren nach Anspruch 1, welches ferner das Einstecken einer Hauptsteuereinheit (35) in einen dritten Steckplatz (33) des gemeinsamen Moduls (3) umfasst, wobei die Hauptsteuereinheit (35) Signale über einen Bus (30) zum ersten Steckplatz (31) und zum zweiten Steckplatz (32) liefert.

3. Verfahren nach Anspruch 2, welches ferner einen Chipsatz mit der Hauptsteuereinheit (35) koppelt und die Signale über den Chipsatz zum ersten Bus (30) überträgt.

4. Verfahren nach Anspruch 2,
Vorsehen einer Vielzahl von ersten Abschlusswiderständen (RA0-RA2) und einer Vielzahl von zweiten Abschlusswiderständen (CA0-CA2) für die Abschlussleiterplatte; und
Abgleichen des ersten Abschlusswiderstandes (RA0-RA2) mit Adressensignalen (A0-A2) unter den Signalen, und
Abgleichen des zweiten Abschlusswiderstandes (CA0-CA2) mit Steuersignalen (C0-C2) unter den Signalen.

5. Verfahren nach Anspruch 1, welches ferner das entsprechende Koppeln der Abschlussleiterplatte (34) mit dem Bus (30) umfasst.

## Revendications

1. Procédé d'utilisation d'un module commun (3) fonctionnant dans un premier mode ou un second mode et possédait une première fente (31) et une deuxième fente (32), et un bus (30), dans lequel une mémoire vive dynamique synchrone II à double débit de données (DDRII SDRAM) et une DDRIII SDRAM peuvent être insérées, comprenant l'étape consistant à :
coupler la première fente (31) et la deuxième fente (32) au bus (30) ;
**caractérisé par** les étapes consistant à :
dans le premier mode,
insérer la DDRII SDRAM dans la première fente (31) ; et
insérer une carte de circuit imprimé d'extrémité (34) dans la deuxième fente (32) ;
dans le second mode,
retirer la DDRII SDRAM de la première fente (31) ;
retirer la carte de circuit imprimé (34) de la deuxième fente (32) ; et
insérer la DDRII SDRAM dans la deuxième fente (32).

2. Procédé selon la revendication 1, comprenant en outre l'étape consistant à insérer un dispositif de commande principal (35) dans une troisième fente (33) du module commun (3), dans lequel le dispositif de commande principal (35) fournit des signaux à la première fente (31) et à la deuxième fente (32) par l'intermédiaire d'un bus (30).

3. Procédé selon la revendication 2, comprenant en outre les étapes consistant à coupler un jeu de puces au dispositif de commande principal (35) et à transmettre les signaux au premier bus (30) par l'intermédiaire du jeu de puces.

4. Procédé selon la revendication 2, comprenant en outre les étapes consistant à :
fournir une pluralité de premières résistances d'extrémité (RA0-RA2) et une pluralité de secondes résistances d'extrémité (CA0-CA2) à la carte de circuit imprimé ; et
faire correspondre les premières résistances d'extrémité (RA0-RA2) à des signaux d'adresse (A0-A2) parmi les signaux, et
faire correspondre les secondes résistances d'extrémité (CA0-CA2) à des signaux de commande (C0-C2) parmi les signaux.

5. Procédé selon la revendication 1, comprenant en outre l'étape consistant à coupler de façon correspondante la carte de circuit imprimé (34) au bus (30).
